# EUROPEAN PATENT APPLICATION

(11) **EP 4 636 903 A1**
(43) Date of publication of application: **22.10.2025**
(21) Application number: 25164016.5
(22) Date of filing: 17.03.2025
(51) Int. Cl.: H01M 10/42

(54) **ELECTRODE ASSEMBLY SHORT CIRCUIT TEST DEVICE AND METHOD FOR RECHARGEABLE BATTERY**

(30) Priority: 21.03.2024 KR 20240039351
(71) Applicant: SAMSUNG SDI CO., LTD., Yongin-si, Gyeonggi-do 17084 (KR)
(72) Inventor: SHIN, Eui-Chol, 17084 Gyeonggi-do (KR)
(74) Representative: Michalski Hüttermann & Partner Patentanwälte mbB

(57) **Abstract**

An electrode assembly short-circuit test apparatus for a rechargeable battery, includes: a first plate to press a first side of an electrode assembly, the electrode assembly including a negative electrode, a positive electrode, and a separator between the negative electrode and the positive electrode; a second plate to press a second side of the electrode assembly against the first plate; and a continuous pulser connected to a negative electrode tab and a positive electrode tab of the electrode assembly to apply continuous pulses to the negative electrode tab and the positive electrode tab.

## Description

### BACKGROUND

### 1. Field

Aspects of embodiments of the present disclosure relate to an electrode assembly short-circuit test apparatus, and an electrode assembly short-circuit test method for a rechargeable battery.

### 2. Description of the Related Art

A rechargeable battery may be repeatedly charged and discharged, unlike a primary battery. A low-capacity rechargeable battery is used for small portable electronic devices, such as a mobile phone, a notebook computer, and a camcorder. A large-capacity rechargeable battery is used as a power supply for driving a motor, such as for a hybrid car.

For example, the rechargeable battery includes an electrode assembly that performs charging and discharging, a pouch that accommodates the electrode assembly, and an electrode terminal that is electrically connected to the electrode assembly and is drawn out to the outside of the pouch. The electrode assembly includes a winding kind in which negative and positive electrode plates are provided on opposite sides and wound with a separator therebetween, and a stacking kind in which negative and positive electrode plates are stacked on opposite sides with a separator therebetween.

The above information disclosed in this Background section is for enhancement of understanding of the background of the present disclosure, and therefore, it may contain information that does not constitute prior art.

### SUMMARY

Medium-to-large sized cells may have larger-area separators stacked in multiple layers, so they may play a role similar to that of a capacitor and are capable of charging. In this case, the separator may have microscopic short circuits, such as microscopic pinholes. After formation, pinholes or micro-short circuits may concentrate electrochemical reactions, which may cause salt precipitation and ignition problems. A principle of short circuit testing is that when a current/voltage is applied to the electrode assembly, the lattice at a micro-short circuit site in the separator impacts with electrons and is ionized, and the additionally generated electrons impact with other lattices and become ionized, raising a temperature in a short period of time and causing a short circuit.

One or more embodiments of the present disclosure may be directed to an electrode assembly short-circuit test apparatus, which applies an enhanced short circuit test method (e.g., a continuous pulse application) when testing a short circuit of an electrode assembly, for a rechargeable battery.

One or more embodiments of the present disclosure may be directed to an electrode assembly short-circuit test apparatus, which detects micro-short circuits in the electrode assembly by improving a surface pressure for pressing the electrode assembly, for a rechargeable battery.

One or more embodiments of the present disclosure may be directed to an electrode assembly short-circuit test method for a rechargeable battery, using the electrode assembly short-circuit test method.

According to one or more embodiments of the present disclosure, an electrode assembly short-circuit test apparatus for a rechargeable battery, includes: a first plate configured to press a first side of an electrode assembly, the electrode assembly including a negative electrode, a positive electrode, and a separator between the negative electrode and the positive electrode; a second plate configured to press a second side of the electrode assembly against the first plate; and a continuous pulser connected to a negative electrode tab and a positive electrode tab of the electrode assembly to apply continuous pulses to the negative electrode tab and the positive electrode tab.

In an embodiment, at least one of the first plate or the second plate may include a silicon pad.

In an embodiment, the first plate and the second plate may include: a first silicon pad in contact with the electrode assembly; and a second silicon pad on the first silicon pad to receive a pressing force.

In an embodiment, the first silicon pad may include a single plate, and the second silicon pad may include a plurality of parts.

In an embodiment, the parts of the second silicon pad may have two kinds of thicknesses and two kinds of hardnesses.

In an embodiment, the first silicon pad of the first and second plates may have a same first thickness and a same first hardness, and the parts of the second silicon pad may differ from each other in at least one of a thickness or a hardness.

In an embodiment, from among the parts of the second silicon pad, a part located at a center in a width direction may have a 21st thickness and a 21st hardness, and from among the parts of the second silicon pad, parts located on an outer edge in the width direction may have a 22nd thickness greater than the 21st thickness and a 22nd hardness greater than the 21st hardness.

In an embodiment, the first silicon pad may have a 31st thickness and a 31st hardness, the parts of the second silicon pad may have a same 32nd thickness as each other, from among the parts of the second silicon pad, a part located at a center in a width direction may have a 33rd hardness, from among the parts of the second silicon pad, a part located on an outer edge in the width direction may have a 34th hardness, and the 33rd hardness may be smaller than the 34th hardness.

In an embodiment, the first silicon pad may have a 41st thickness and a 41st hardness, the parts of the second silicon pad may have a same 42nd hardness as each other, from among the parts of the second silicon pad, a part located at a center in a width direction may have a 43rd thickness, from among the parts of the second silicon pad, a part located on an outer edge in the width direction may have a 44th thickness, and the 43rd thickness may be smaller than the 44th thickness.

In an embodiment, the first plate and the second plate may include: a polypropylene sheet in contact with the electrode assembly; and a silicone pad on the polypropylene sheet to receive a pressing force. The silicon pad may include a plurality of parts.

In an embodiment, the first plate may include a PC sheet or an inclined Teflon pad, and the second plate may include: a tile-type silicon pad; and a jig configured to hold the silicon pad.

According to one or more embodiments of the present disclosure, an electrode assembly short-circuit test method for a rechargeable battery, includes: performing pressurization by using a first plate for supporting a lower surface of an electrode assembly, and a second plate for supporting an upper surface of the electrode assembly from above the first plate, the electrode assembly including a negative electrode, a positive electrode, and a separator between the negative electrode and the positive electrode; applying continuous pulses having a current and a voltage using a continuous pulser to a negative electrode tab and a positive electrode tab of the electrode assembly; measuring the voltage and the current of the continuous pulses applied to the electrode assembly; determining a short circuit if the voltage drops to zero; and determining a charging completion if the current stabilizes.

In an embodiment, in the performing of the pressurization, at least one of the first plate or the second plate may include a silicon pad to perform the pressurization.

In an embodiment, in the performing of the pressurization, the first plate and the second plate may include: a first silicon pad in contact with the electrode assembly; and a second silicon pad on the first silicon pad to receive a pressing force to perform the pressurization.

In an embodiment, in the performing of the pressurization, the first silicon pad may include a single plate, and the second silicon pad may include a plurality of parts to perform the pressurization.

In an embodiment, in the performing of the pressurization, the parts of the second silicon pad may have two kinds of thicknesses and two kinds of hardnesses to perform the pressurization.

In an embodiment, in the performing of the pressurization, the first silicon pad of the first plate and the second plate may have a same first thickness and a same first hardness, and the parts of the second silicon pad may differ from each other in at least one of a thickness or a hardness to perform the pressurization.

In an embodiment, in the performing of the pressurization, from among the parts of the second silicon pad, a part located at a center in a width direction may have a 21st thickness and a 21st hardness, and parts located on an outer edge may have a 22nd thickness greater than the 21st thickness and a 22nd hardness greater than the 21st hardness.

In an embodiment, in the performing of the pressurization, the first silicon pad of the first plate and the second plate may have a same first thickness and a same first hardness, the parts of the second silicon pad may have a same second thickness as each other, and a hardness of parts located on an outer edge from among the parts of the second silicon pad may be higher than a hardness of parts located at a center in a width direction from among the parts of the second silicon pad, to perform the pressurization.

In an embodiment, in the performing of the pressurization, the first silicon pad of the first plate and the second plate may have a same first thickness and a same first hardness, and parts located on an outer edge from among the parts of the second silicon pad may have a 44^{th} thickness that is higher than a 43rd thickness of parts located at a center in a width direction from among the parts of the second silicon pad, to perform pressurization.

According to some embodiments of the present disclosure, continuous pulses may be applied when inspecting a short circuit of an electrode assembly, thereby maximizing or improving short circuit test capabilities. In addition, in some embodiments, surface pressure may be improved by pressing an electrode assembly, so that the surface pressure may be uniformly or substantially uniformly transmitted, thereby effectively detecting micro-short circuits in the electrode assembly that may cause problems in the future.

However, the present disclosure is not limited to the above aspects and features, and the above and the above and other aspects and features will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The above and other aspects and features of the present disclosure will be more clearly understood from the following detailed description of the illustrative, nonlimiting embodiments with reference to the accompanying drawings.
FIG. 1 illustrates a configuration diagram of an electrode assembly short-circuit test apparatus for a rechargeable battery according to a first embodiment of the present disclosure.
FIG. 2 illustrates a configuration diagram of an electrode assembly short-circuit test apparatus for a rechargeable battery according to a second embodiment of the present disclosure.
FIG. 3 illustrates a configuration diagram of an electrode assembly short-circuit test apparatus for a rechargeable battery according to a third embodiment of the present disclosure.
FIG. 4 illustrates a configuration diagram of an electrode assembly short-circuit test apparatus for a rechargeable battery according to a fourth embodiment of the present disclosure.
FIG. 5 illustrates a configuration diagram of an electrode assembly short-circuit test apparatus for a rechargeable battery according to a fifth embodiment of the present disclosure.
FIG. 6 illustrates a configuration diagram of an electrode assembly short-circuit test apparatus for a rechargeable battery according to a sixth embodiment of the present disclosure.
FIG. 7 illustrates an image of a second silicon pad applied to the second and third embodiment of FIG. 2 and metal foreign substances attached thereto.
FIG. 8 illustrates an image of a first silicon pad applied to the first, second and fourth embodiment of FIG.1, FIG. 2 and FIG. 4, and metal foreign substances attached thereto.
FIG. 9 illustrates an image of a first silicon pad applied to the third embodiment of FIG. 3, and metal foreign substances attached thereto.
FIG. 10 illustrates an image of a PP sheet applied to a seventh embodiment of FIG. 20, and metal foreign substances attached thereto.
FIG. 11 illustrates a top plan view showing a position for a short circuit test of an electrode assembly for a rechargeable battery applied to one or more embodiments of the present disclosure.
FIG. 12 illustrates an image showing a surface pressure distribution of an electrode assembly for a rechargeable battery according to a comparative example.
FIG. 13 illustrates an image showing a surface pressure distribution of an electrode assembly when the electrode assembly short circuit test apparatus for a rechargeable battery according to the first embodiment of the present disclosure is applied.
FIG. 14 illustrates an image showing a surface pressure distribution of an electrode assembly when the electrode assembly short circuit test apparatus for a rechargeable battery according to the second embodiment of the present disclosure is applied.
FIG. 15 illustrates an image showing a surface pressure distribution of an electrode assembly when the electrode assembly short circuit test apparatus for a rechargeable battery according to the third embodiment of the present disclosure is applied.
FIG. 16 illustrates an image showing a surface pressure distribution of an electrode assembly when the electrode assembly short circuit test apparatus for a rechargeable battery according to the fourth embodiment of the present disclosure is applied.
FIG. 17 illustrates a flowchart showing an electrode assembly short-circuit test method for a rechargeable battery according to an embodiment of the present disclosure.
FIG. 18 illustrates a graph showing that a voltage drops to zero and is determined to be a short circuit in the test method of FIG. 17.
FIG. 19 illustrates a graph showing that a current is stable and charging is determined to be complete in the test method of FIG. 17.
FIG. 20 illustrates a configuration diagram of an electrode assembly short-circuit test apparatus for a rechargeable battery according to the seventh embodiment of the present disclosure.
FIG. 21 illustrates an image showing a surface pressure distribution of an electrode assembly when the electrode assembly short circuit test apparatus for a rechargeable battery according to the seventh embodiment of the present disclosure is applied.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

When a pulse is applied to an electrode assembly, or in other words, when 500 V of the International Insulation Resistance Measurement Standard (IEC93) is applied continuously at short time intervals, a portion of a separator in the electrode assembly with weak insulation may be short-circuited and may also be detected. When 500V is applied once to a micro-short circuit that may be difficult to detect or it may not be detected, but when applied as a pulse kind, a detection power increases and the short circuit may be effectively detected.

When 500V is applied once, a pulse current passes through the micro-short circuit and generates heat, but thermal equilibrium may be achieved within a short period of time and insulation may be restored. However, a principle of detection using the continuous pulse method is that a pulse current is continuously applied before thermal equilibrium is achieved at the micro-short circuit site, allowing the micro-short-circuit site to be detected through the accumulation of thermal energy.

An electrode assembly short circuit test method according to embodiments of the present disclosure may apply continuous pulses to the electrode assembly to determine whether or not the electrode assembly has a micro short circuit, and whether or not charging is completed. The electrode assembly short circuit test apparatus according to embodiments of the present disclosure may implement the electrode assembly short circuit test method. For convenience, an electrode assembly short-circuit test apparatus for a rechargeable battery will be described first hereinafter.

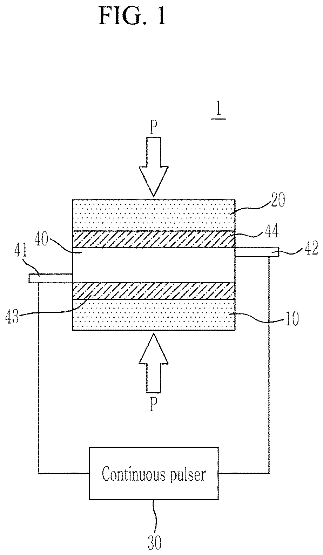

FIG. 1 illustrates a configuration diagram of an electrode assembly short-circuit test apparatus for a rechargeable battery according to a first embodiment of the present disclosure.

Referring to FIG. 1, the electrode assembly short circuit test apparatus 1 according to the first embodiment includes a first plate 10 (hereinafter, referred to interchangeably with a "lower plate"), a second plate 20 (hereinafter, referred to interchangeably with an "upper plate"), and a continuous pulser 30.

The lower plate 10 supports and presses (P) a first surface (e.g., a lower surface) of an electrode assembly 40, in which a negative electrode and a positive electrode are positioned with a separator provided therebetween. The upper plate 20 supports and presses (P) a second surface (e.g., an upper surface) of the electrode assembly 40 from above, which is opposite to the lower plate 10.

The lower plate 10 and the upper plate 20 may increase a detection rate of foreign substances in the electrode assembly 40 by improving a surface pressure on parts of the electrode assembly 40 that may not be easily pressed.

As an example, at least one of the lower plate 10 or the upper plate 20 may be formed of a silicon pad. In the first embodiment, silicone pads may be applied to the lower and upper plates 10 and 20 to uniform or substantially uniform the surface pressure. As an example, the silicone pads may have a thickness of 7 mm, and a hardness of 50 degrees.

The continuous pulser 30 may be connected to a negative electrode tab 41 and a positive electrode tab 42 of the electrode assembly 40 to apply continuous pulses. Application of the continuous pulses may increase a foreign substance detection rate for an easily pressed portion of the electrode assembly 40.

According to the first embodiment, with respect to the entire area of the electrode assembly 40, the foreign substance detection rate may be further increased (e.g., may be greatly increased) by improving the surface pressure on parts that may not be easily pressed with the lower and upper plates 10 and 20, and by applying the continuous pulses to the parts that may not be easily pressed with the continuous pulser 30 (e.g., a continuous pulse machine).

In addition, when pressure-sensitive papers 43 and 44 are provided on the lower and upper surfaces of the electrode assembly 40, respectively, and the electrode assembly 40 is pressed with the lower and upper plates 10 and 20, it may be possible to directly visually check whether or not the surface pressure on the electrode assembly 40 is uniform or substantially uniform through the pressure-sensitive papers 43 and 44.

Hereinafter, some other embodiments of the present disclosure will be described in more detail. When compared to the first embodiment and previously described embodiments above, redundant description of the same or substantially the same (or similar) components may not be repeated, and the differences therebetween may be described in more detail hereinafter.

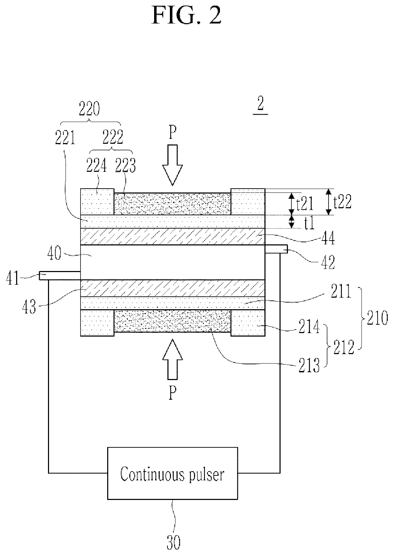

FIG. 2 illustrates a configuration diagram of an electrode assembly short-circuit test apparatus for a rechargeable battery according to a second embodiment of the present disclosure.

Referring to FIG. 2, in the electrode assembly short circuit test apparatus 2 according to the second embodiment, a first plate 210 and a second plate 220 include first silicon pads 211 and 221 that are in contact with the electrode assembly 40, and second silicon pads 212 and 222 that are positioned on the first silicon pads 211 and 221 for receiving a pressing force.

The first silicon pads 211 and 221 of the first and second plates 210 and 220 may each be formed as a single plate to support and pressurize (P) the lower and upper surfaces of the electrode assembly 40. The second silicon pads 212 and 222 may each be formed of a plurality of pieces (e.g., a plurality of parts). The pieces (e.g., the parts) of the second silicon pads 212 and 222 may have two kinds of thicknesses and two kinds of hardnesses.

In the second embodiment, the first silicon pads 211 and 221 of the first and second plates 210 and 220 may have the same or substantially the same first thickness t1 and the same or substantially the same first hardness as each other. As an example, the first silicon pads 211 and 221 may have a first thickness t1 of 3 mm and a first hardness of 50 degrees. Pieces (e.g., parts) of the second silicon pads 212 and 222 may be formed to be different from each other in at least one of a thickness or a hardness.

In the second embodiment, from among the pieces of the second silicon pads 212 and 222 of the first and second plates 210 and 220, the pieces (e.g., the parts) 213 and 223 positioned at a center in the width direction (e.g., left and right directions in FIG. 2) may have a 21st thickness t21 and a 21st hardness. As an example, the pieces 213 and 223 may have the 21st thickness t21 of 3 mm and the 21st hardness of 50 degrees. The pieces (e.g., the parts) 214 and 224 positioned on the outside may have a 22nd thickness t22 greater than the 21st thickness t21, and/or a 22nd hardness greater than the 21st hardness. As an example, the pieces 214 and 224 may have the 22nd thickness t22 of 6 mm and the 22nd hardness of 50 degrees.

The continuous pulser 30 may be connected to the negative electrode tab 41 and the positive electrode tab 42 of the electrode assembly 40 to apply continuous pulses. Application of the continuous pulses may increase a foreign substance detection rate for an easily pressed portion of the electrode assembly 40.

According to the second embodiment, with respect to the entire area of the electrode assembly 40, a foreign substance detection rate may be further increased (e.g., may be greatly increased) by improving the surface pressure on parts that are not suitably pressed (e.g., that are not pressed well) with the first silicon pads 211 and 221 and the second silicon pads 212 and 222 of the lower and upper plates 210 and 220, and applying the continuous pulses to the parts that are easily pressed by the continuous pulser 30.

A thickness of the pieces 214 and 224 positioned on the outside may be greater than those of the pieces 213 and 223 positioned at the center in the width direction, and the hardness thereof may be higher, and thus, the surface pressure on the parts that are relatively less pressed may be improved, so that with respect to the entire area of the electrode assembly 40, the foreign substance detection rate may be increased (e.g., may be greatly increased).

In addition, when pressing (P) the electrode assembly 40 with the first silicon pads 211 and 221 and the second silicon pads 212 and 222 of the lower and upper plates 210 and 220 by providing the pressure-sensitive papers 43 and 44 on the lower and upper surfaces of the electrode assembly 40, respectively, it may be possible to directly visually check whether or not the surface pressure on the electrode assembly 40 is uniform or substantially uniform through the pressure-sensitive papers 43 and 44.

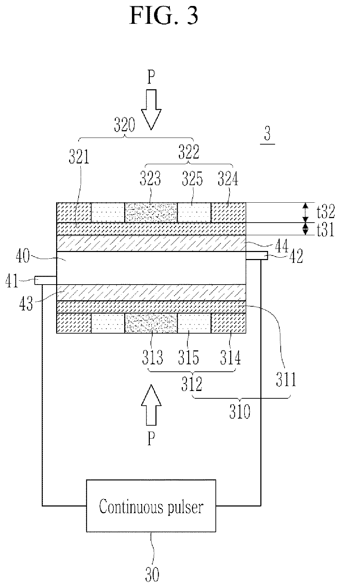

FIG. 3 illustrates a configuration diagram of an electrode assembly short-circuit test apparatus for a rechargeable battery according to a third embodiment of the present disclosure.

Referring to FIG. 3, in the electrode assembly short circuit test apparatus 3 of the third embodiment, a first plate 310 and a second plate 320 may include first silicon pads 311 and 321 that are in contact with the electrode assembly 40, and second silicon pads 312 and 322 that are positioned on the first silicon pads 311 and 321 for receiving a pressing force.

The first silicon pads 311 and 321 of the first and second plates 310 and 320 may each be formed as a single plate to support and pressurize (P) the lower and upper surfaces of the electrode assembly 40. The second silicon pads 312 and 322 may each be formed of a plurality of pieces (e.g., a plurality of parts). Pieces (e.g., parts) of the second silicon pads 312 and 322 may have at least two kinds of hardnesses.

In the third embodiment, the first silicon pads 311 and 321 of the first and second plates 310 and 320 may have a 31st thickness t31 and a 31st hardness. As an example, the first silicon pads 311 and 321 have a 31st thickness t31 of 3 mm, and a 31st hardness of 80 degrees.

In the third embodiment, pieces (e.g., parts) of the second silicon pads 312 and 322 of the first and second plates 310 and 320 may have the same 32nd thickness t32 as each other. As an example, the 32nd thickness t32 may be 5mm. Among the pieces of the second silicon pads 312 and 322, pieces (e.g., parts) 313 and 323 positioned in the center in the width direction (e.g., left and right directions in FIG. 3) may have a 33rd hardness, and as an example, the pieces 313 and 323 may have the 33rd hardness of 20 degrees. Pieces (e.g., parts) 314 and 324 positioned on the outside may have a 34th hardness, for example, such as the 34th hardness of 80 degrees. The 33rd hardness at the center in the width direction may be smaller than the 34th hardness at an outer edge in the width direction.

Additionally, in the third embodiment, the second silicon pads 312 and 322 may further include pieces (e.g., parts) 315 and 325 inserted between the central pieces 313 and 323 and the outer pieces 314 and 324. As an example, the inserted pieces 315 and 325 may have a 32st thickness t32 of 5 mm, and a 35th hardness of 50 degrees. In other words, the second silicon pads 312 and 322 may have the same or substantially the same thickness as each other, and the hardness of the pieces (the parts) may gradually decrease from the outer edge to the center in the width direction.

According to the third embodiment, with respect to the entire area of the electrode assembly 40, a foreign substance detection rate may be increased (e.g., may be greatly increased) by improving the surface pressure on parts that are not pressed well with the first silicon pads 311 and 321 and the second silicon pads 312 and 322 of the lower and upper plates 310 and 320, and applying continuous pulses to parts that are easily pressed by the continuous pulser 30.

The hardness of the inserted pieces 315 and 325 may be higher than that of the pieces 313 and 323 positioned at the center in the width direction, and the hardness of the pieces 314 and 324 positioned on the outside may be higher than that of the inserted pieces 315 and 325. Accordingly, the surface pressure may be further improved for the parts that were relatively less pressed, and thus, the foreign substance detection rate may be further increased (e.g., may be greatly increased) for the entire area of the electrode assembly 40.

In addition, when pressing (P) the electrode assembly 40 with the first silicon pads 311 and 321 and the second silicon pads 312 and 322 of the lower and upper plates 310 and 320 by providing pressure-sensitive papers 43 and 44 on the lower and upper surfaces of the electrode assembly 40, respectively, it may be possible to directly visually check whether or not the surface pressure on the electrode assembly 40 is uniform or substantially uniform through the pressure-sensitive papers 43 and 44.

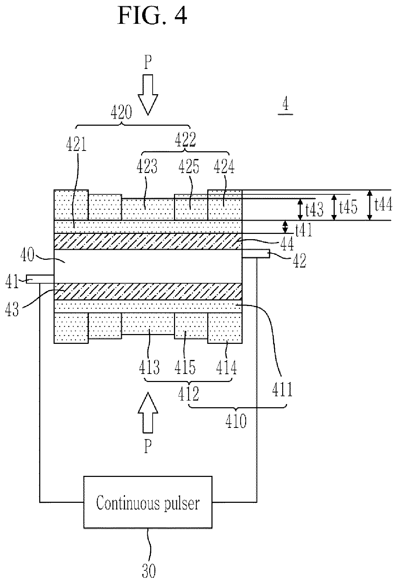

FIG. 4 illustrates a configuration diagram of an electrode assembly short-circuit test apparatus for a rechargeable battery according to a fourth embodiment of the present disclosure.

Referring to FIG. 4, in the electrode assembly short circuit test apparatus 4 of the fourth embodiment, a first plate 410 and a second plate 420 may include first silicon pads 411 and 421 that are in contact with the electrode assembly 40, and second silicon pads 412 and 422 positioned on the first silicon pads 411 and 421 for receiving a pressing force.

The first silicon pads 411 and 421 of the first and second plates 410 and 420 may each be formed as a single plate to support and pressurize (P) the lower and upper surfaces of the electrode assembly 40. The second silicon pads 412 and 422 may each be formed of a plurality of pieces (e.g., a plurality of parts or a plurality of plate parts). Pieces (e.g., parts) of the second silicon pads 412 and 422 may have at least two kinds of thicknesses.

In the fourth embodiment, the first silicon pads 411 and 421 of the first and second plates 410 and 420 may have a 41st thickness t41 and a 41st hardness. As an example, the first silicon pads 411 and 421 may have the 41st thickness t41 of 3 mm, and the 41st hardness of 50 degrees.

In the fourth embodiment, pieces (e.g., parts) of the second silicon pads 412 and 422 of the first and second plates 410 and 420 may have the same 42nd hardness as each other. For example, the 42nd hardness may be 50 degrees. Among the pieces of the second silicon pads 412 and 422, the pieces 413 and 423 located at the center in the width direction (e.g., left and right directions in FIG. 4) may have a 43rd thickness t43, and as an example, the pieces 413 and 423 may have the 43rd thickness t43 of 5 mm. Pieces (e.g., parts) 414 and 424 positioned on the outside may have a 44th thickness t44, and as an example, the pieces 414 and 424 may have the 44th thickness t44 of 7 mm. The 43rd thickness t43 at the center in the width direction may be smaller than the 44th thickness t44 at the outer edge in the width direction.

Additionally, in the fourth embodiment, the second silicon pads 412 and 422 may further include pieces (e.g., parts) 415 and 425 inserted between the central pieces 413 and 423 and the outer pieces 414 and 424. As an example, the inserted pieces 415 and 425 may have a 45th thickness t45 of 6 mm. In other words, the second silicon pads 412 and 422 may have the same or substantially the same hardness as each other, and the thickness of the pieces (e.g., the parts) may gradually decrease from the outer edge to the center in the width direction.

According to the fourth embodiment, with respect to the entire area of the electrode assembly 40, a foreign substance detection rate may be increased (e.g., may be greatly increased) by improving the surface pressure on parts that are not pressed well with the first silicon pads 411 and 421 and the second silicon pads 412 and 422 of the lower and upper plates 410 and 420, and applying continuous pulses to parts that are easily pressed by the continuous pulser 30.

A thickness of the inserted pieces 415 and 425 may be greater than a thickness of the pieces 413 and 423 positioned at the center in the width direction, and a thickness of the outer pieces 414 and 424 may be greater than a thickness of the inserted pieces 415 and 425, and thus, the surface pressure on the parts that are relatively less pressed may be further improved, so that with respect to the entire area of the electrode assembly 40, the foreign substance detection rate may be increased (e.g., may be greatly increased).

In addition, when pressing (P) the electrode assembly 40 with the first silicon pads 411 and 421 and the second silicon pads 412 and 422 of the lower and upper plates 410 and 420 by providing the pressure-sensitive papers 43 and 44 on the lower and upper surfaces of the electrode assembly 40, it may be possible to directly visually check whether or not the surface pressure on the electrode assembly 40 is uniform or substantially uniform through the pressure-sensitive papers 43 and 44.

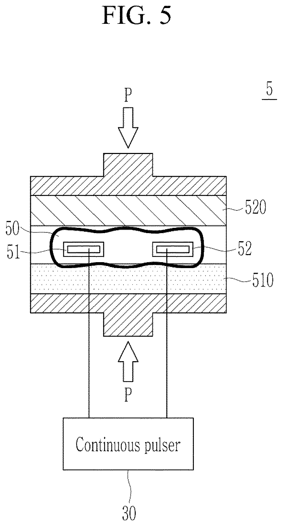

FIG. 5 illustrates a configuration diagram of an electrode assembly short-circuit test apparatus for a rechargeable battery according to a fifth embodiment of the present disclosure.

Referring to FIG. 5, in the electrode assembly short circuit test apparatus 5 according to the fifth embodiment, a lower plate 510 may be formed of a micro nylon pad, and an upper plate 520 may be formed of a Teflon pad.

According to the fifth embodiment, with respect to the entire area of the electrode assembly 50, the foreign substance detection rate may be increased (e.g., may be greatly increased) by improving the surface pressure on the parts that are not easily pressed with the nylon pad and Teflon pad of the lower and upper plates 510 and 520, and by applying continuous pulses to the parts that are easily pressed with the continuous pulse machine 30. The continuous pulser 30 may be connected to a negative electrode tab 51 and a positive electrode tab 52 of the electrode assembly 50 to apply the continuous pulses.

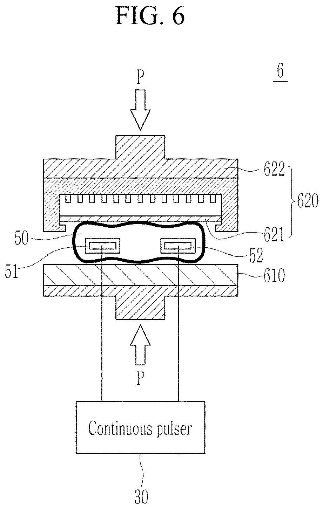

FIG. 6 illustrates a configuration diagram of an electrode assembly short-circuit test apparatus for a rechargeable battery according to a sixth embodiment of the present disclosure.

Referring to FIG. 6, in the electrode assembly short circuit test apparatus 6 according to the sixth embodiment, a lower plate 610 may be formed of a PC sheet or an inclined Teflon pad, and an upper plate 620 may include a tile-type silicon pad 621 and a jig 622 that holds the silicon pad 621. The tile-type silicon pad 621 may have a concavo-convex structure on an opposite side of the electrode assembly 50, and thus, the silicon pad 621 may effectively improve the surface pressure on the hard-to-press part of the electrode assembly 50.

According to the sixth embodiment, with respect to the entire area of the electrode assembly 50, the foreign substance detection rate may be increased (e.g., may be greatly increased) by improving the surface pressure on the parts that are not easily pressed with the inclined Teflon pad and silicone pad 621 of the lower and upper plates 610 and 620, and by applying continuous pulses to the parts that are easily pressed with the continuous pulse machine 30.

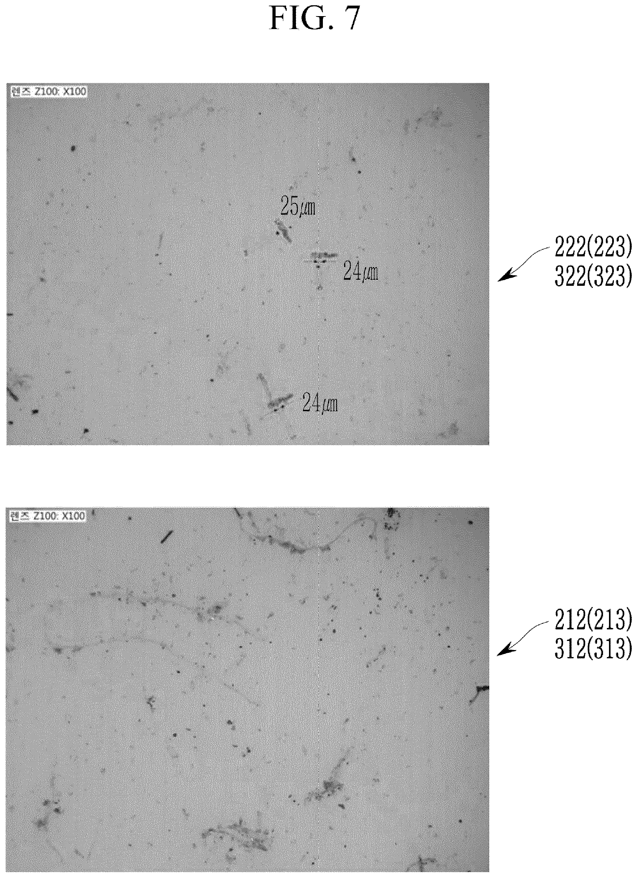

FIG. 7 illustrates an image of a second silicon pad (e.g., having a hardness of 20 degrees) applied to the second and third embodiment of FIG. 2 and FIG.3, and metal foreign substances attached thereto.

Referring to FIG. 7, the second silicon pads 212, 222, 312 and 322may have the hardness of 20 degrees, and may absorb a lot (e.g., an increased amount) of foreign substances and dust. For example, metal foreign substances attached to the surface may have a particle diameter of 25 µm or less.

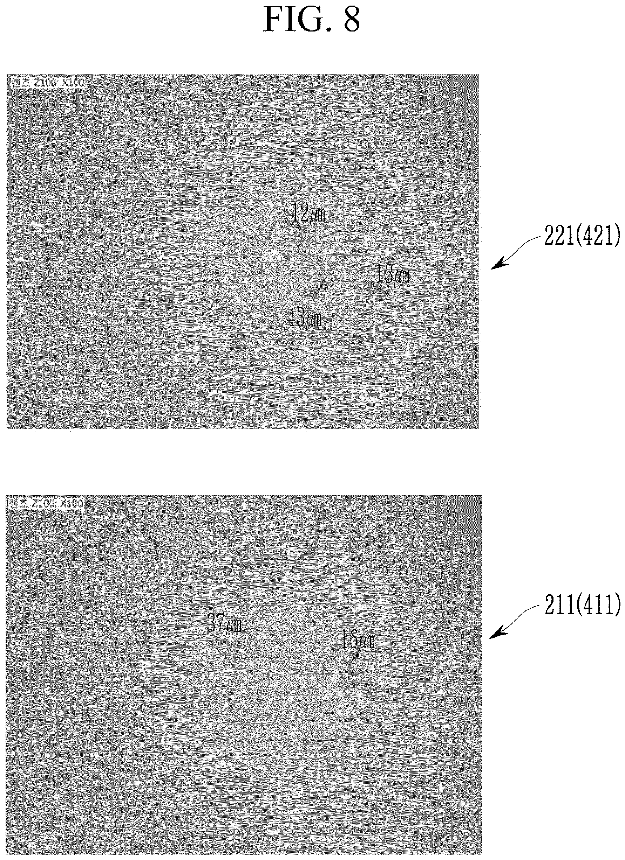

FIG. 8 illustrates an image of a first silicon pad (e.g., having a hardness of 50 degrees) applied to the first, second and fourth embodiment of FIG. 1, 2 and 4, and metal foreign substances attached thereto.

Referring to FIG. 8, the first silicon pads 211, 221, 411 and 421 may have the hardness of 50 degrees, and may absorb foreign substances and dust. For example, metal foreign substances attached to the surface may have a particle diameter of 10 µm to 50 µm.

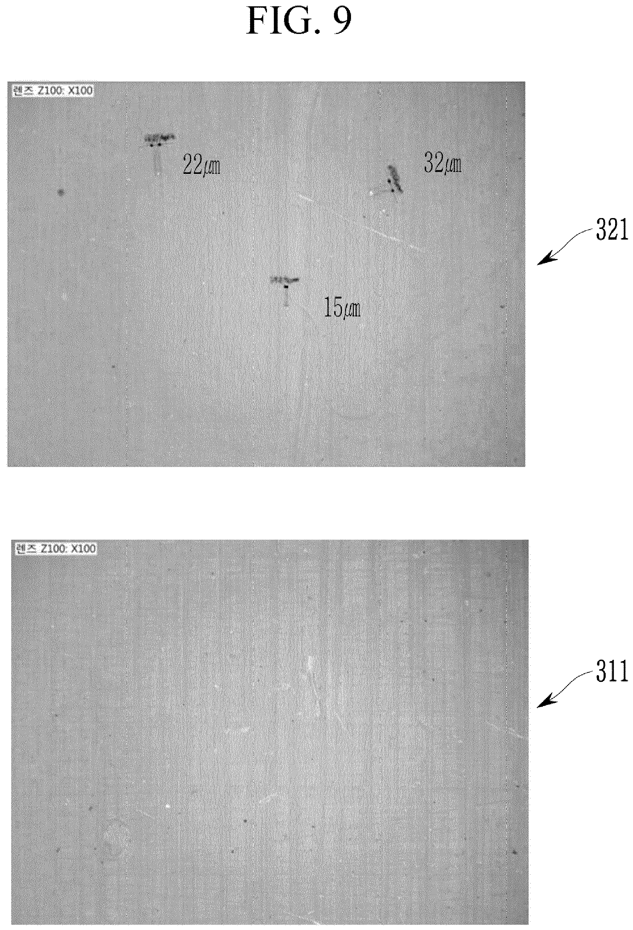

FIG. 9 illustrates an image of a first silicon pad (e.g., having a hardness of 80 degrees) applied to the third embodiment of FIG. 3, and metal foreign substances attached thereto.

Referring to FIG. 9, the first silicon pads 311 and 321 may have the hardness of 80 degrees, and may absorb foreign substances and dust. For example, metal foreign substances attached to the surface may have a particle diameter of 10 µm to 50 µm.

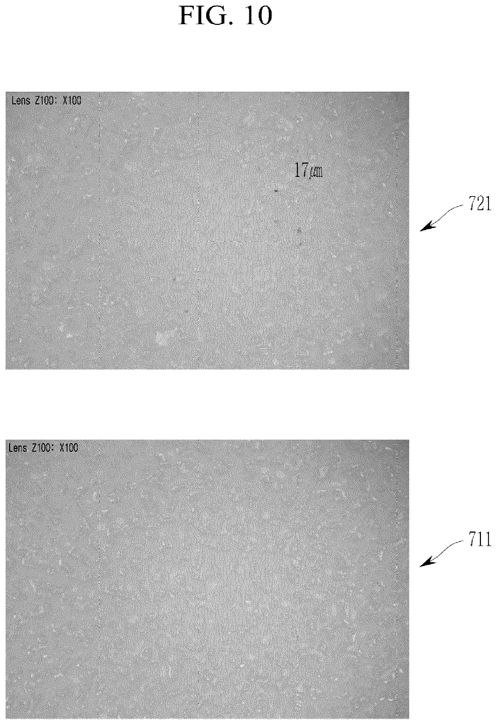

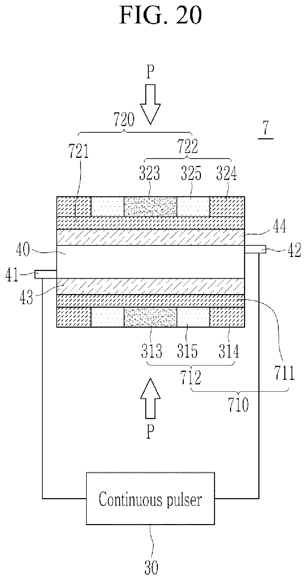

FIG. 10 illustrates an image of a PP sheet applied to a seventh embodiment of FIG. 20, and metal foreign substances attached thereto.

Referring to FIG. 10, a degree of adhesion of foreign substances to surfaces of polypropylene (PP) sheets 711 and 721 may be lower (e.g., may be significantly lower) than that of the first silicon pad.

FIG. 20 illustrates a configuration diagram of an electrode assembly short-circuit test apparatus for a rechargeable battery according to the seventh embodiment of the present disclosure.

Referring to FIG. 20, in the electrode assembly short circuit test apparatus 7 according to the seventh embodiment, the first plate 710 and the second plate 720 may include the PP sheets 711 and 721 that are in contact with the electrode assembly 40, and silicon pads 712 and 722 that are positioned on the PP sheets 711 and 721 to receive a pressing force.

The PP sheets 711 and 721 of the first and second plates 710 and 720 may each be formed as a single sheet to support and pressurize (P) the lower and upper surfaces of the electrode assembly 40. The silicon pads 712 and 722 may each be formed of a plurality of pieces (e.g., a plurality of parts). Pieces (e.g., parts) of the silicon pads 712 and 722 may have at least two kinds of hardnesses. Because the silicon pads 712 and 722 may have the same or substantially the same structure as those of the second silicon pads 312 and 322 of the third embodiment described above, redundant description of the silicon pads 712 and 722 may not be repeated.

According to the seventh embodiment, with respect to the entire area of the electrode assembly 40, a foreign substance detection rate may be increased (e.g., may be greatly increased) by improving the surface pressure on the parts that are not pressed well with the PP sheets 711 and 721 and the silicon pads 712 and 722 of the lower and upper plates 710 and 720, and applying continuous pulses to the parts that are easily pressed by the continuous pulser 30.

Referring to FIGS. 7 to 10, as the hardness of the silicon pad increases, a degree of adsorption of the surface foreign substances may decrease. A size of the metal foreign substances attached to the surface of the silicon pad may be 10 µm to 50 µm. In addition, when the PP sheets 711 and 721 are provided between the silicon pads 712 and 722 and the electrode assemblies 40 and 50, adsorption of foreign substances may be ameliorated (e.g., may be greatly ameliorated).

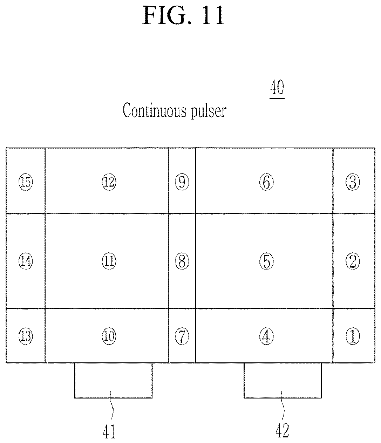

FIG. 11 illustrates a top plan view showing a position for a short circuit test of an electrode assembly for a rechargeable battery applied to one or more embodiments of the present disclosure.

Referring to FIG. 11, a top plan view of the electrode assembly 40 applied to the first to fourth embodiments is shown divided into first to fifteenth regions (① to ⑮) having the corresponding number indicated for each of the regions.

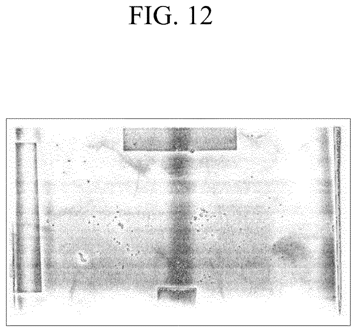

FIG. 12 illustrates an image showing a surface pressure distribution of an electrode assembly for a rechargeable battery according to a comparative example.

Referring to FIG. 12, a surface pressure distribution obtained through a pressure-sensitive paper is shown when an electrode assembly is pressed with first and second plates of an electrode assembly short circuit test apparatus for a rechargeable battery that does not use a silicon pad.

Referring to FIGS. 11 and 12, when the applied pressure (P) is 0.94 Ma, pressure may be applied to 68% of the entire area of the electrode assembly. Further pressure is provided in 7th to 9th regions ⑦ to ⑨, which are a core portion of the electrode assembly, 1st to 3rd regions ① to ③ and 13th to 15th regions ⑬ to ⑮, which are round portions, and 6th, 9th, and 12th regions ⑥, ⑨, and ⑫, which are taping regions.

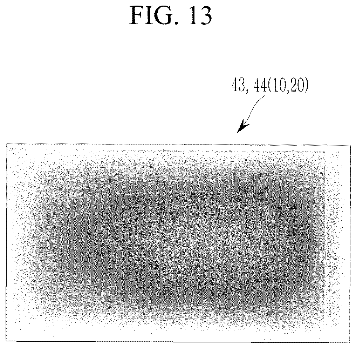

FIG. 13 illustrates an image showing a surface pressure distribution of an electrode assembly when the electrode assembly short circuit test apparatus for a rechargeable battery according to the first embodiment of the present disclosure is applied.

Referring to FIG. 13, the surface pressure distribution obtained through the pressure sensitive papers 43 and 44 is shown, when the electrode assembly 40 is pressed with the first and second plates 10 and 20 formed of the silicone pad of the first embodiment.

Referring to FIGS. 11 and 13, when the applied pressure (P) is 1.5 Ma, pressure may be applied to 86% of the entire area of the electrode assembly. Less pressure may be provided in 1st to 3rd regions ① to ③, 13th to 15th regions ⑬ to ⑮, 6th, 9th, and 12th regions ⑥, ⑨, and ⑫, and 4th, 7th, and 11th ④, ⑦, and ⑪, which are edge portions of the electrode assembly. As such, the surface pressure distribution may be improved in the first embodiment compared to the comparative example.

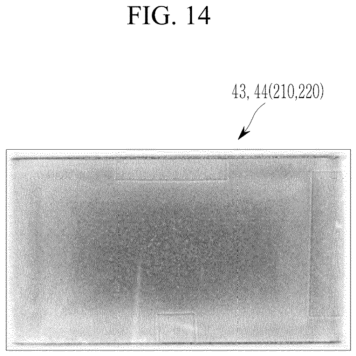

FIG. 14 illustrates an image showing a surface pressure distribution of an electrode assembly when the electrode assembly short circuit test apparatus for a rechargeable battery according to the second embodiment of the present disclosure is applied.

Referring to FIG. 14, the surface pressure distribution obtained through the pressure sensitive papers 43 and 44 is shown, when the electrode assembly 40 is pressed with the first and second plates 210 and 220 formed of the silicone pad of the second embodiment.

Referring to FIGS. 11 and 14, when the applied pressure (P) is 1.5 Ma, pressure may be applied to 100% of the entire area of the electrode assembly. Less pressure may be ameliorated in 1st to 3rd regions ① to ③, 13th to 15th regions ⑬ to ⑮, 6th, 9th, and 12th regions ⑥, ⑨, and ⑫, and 4th, 7th, and 11th ④, ⑦, and ⑪, which are edge portions of the electrode assembly. As such, the surface pressure distribution may be improved in the second embodiment compared to the first embodiment.

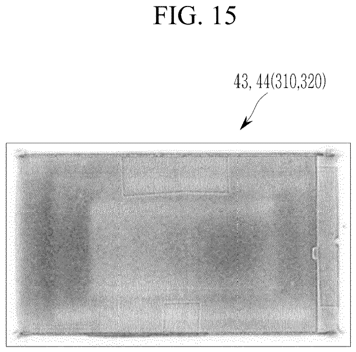

FIG. 15 illustrates an image showing a surface pressure distribution of an electrode assembly when the electrode assembly short circuit test apparatus for a rechargeable battery according to the third embodiment of the present disclosure is applied.

Referring to FIG. 15, the surface pressure distribution obtained through the pressure sensitive papers 43 and 44 is shown, when the electrode assembly 40 is pressed with the first and second plates 310 and 320 formed of the silicone pad of the third embodiment.

Referring to FIGS. 11 and 15, when the applied pressure (P) is 1.5 Ma, pressure may be applied to 100% of the entire area of the electrode assembly. Less pressure may be ameliorated in 7th to 9th regions ⑦, ⑧, and ⑨, which are a central portion of the electrode assembly. As such, the surface pressure distribution may be uniformly improved in the third embodiment compared to the second embodiment.

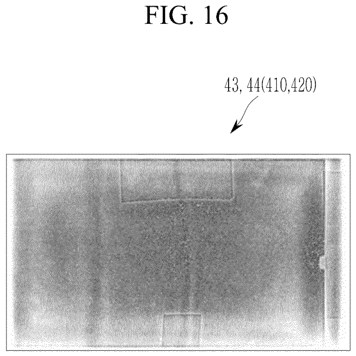

FIG. 16 illustrates an image showing a surface pressure distribution of an electrode assembly when the electrode assembly short circuit test apparatus for a rechargeable battery according to the fourth embodiment of the present disclosure is applied.

Referring to FIG. 16, the surface pressure distribution obtained through the pressure sensitive papers 43 and 44 is shown, when the electrode assembly 40 is pressed with the first and second plates 410 and 420 formed of the silicone pad of the fourth embodiment.

Referring to FIGS. 11 and 16, when the applied pressure (P) is 1.5 Ma, pressure may be applied to 100% of the entire area of the electrode assembly. Less pressure may be applied in the 4th and 10th regions ④ and ⑩, which are the tab portions of the electrode assembly. As such, the surface pressure distribution may be generally similar in the fourth embodiment compared to the third embodiment.

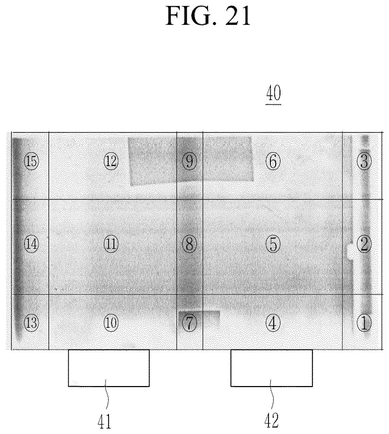

FIG. 21 illustrates an image showing a surface pressure distribution of an electrode assembly when the electrode assembly short circuit test apparatus for a rechargeable battery according to the seventh embodiment of the present disclosure is applied.

Referring to FIG. 21, the surface pressure distribution obtained through the pressure sensitive papers 43 and 44 is shown, when the electrode assembly 40 is pressed with the first and second plates 710 and 720 formed of the silicone pad of the seventh embodiment.

Referring to FIGS. 11 and 21, when applied pressure P is applied in various ways, less pressure may be ameliorated, and foreign substances may be detected in the first, fourth, seventh, 10th, and 13th regions , , ⑦, ⑩, and ⑬ of the electrode assembly.

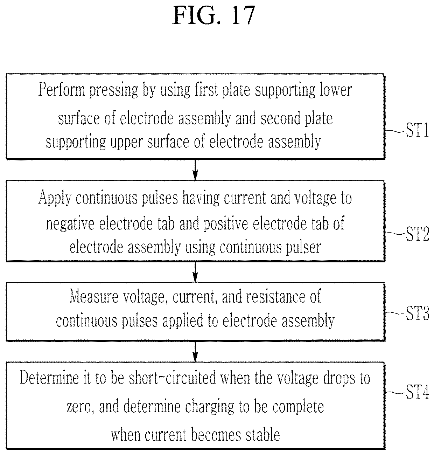

FIG. 17 illustrates a flowchart showing an electrode assembly short-circuit test method for a rechargeable battery according to an embodiment of the present disclosure.

The electrode assembly short-circuit test method for a rechargeable battery according to an embodiment includes a first operation ST1, a second operation ST2, a third operation ST3, and a fourth operation ST4. First, a test method by applying the test apparatus of the first embodiment will be described in more detail.

Referring to FIGS. 1 and 17, the first operation ST1 performs pressing (P) by using the first plate 10 supporting a lower surface of the electrode assembly 40 (e.g., on which a negative electrode and a positive electrode are positioned with a separator therebetween) and the second plate 20 supporting an upper surface of the electrode assembly 40 above the first plate 10.

In the first embodiment, in the first operation ST1, at least one of the first plate 10 or the second plate 20 may be formed of a silicon pad to perform pressurization. A pressure distribution as shown in FIG. 13 may be obtained.

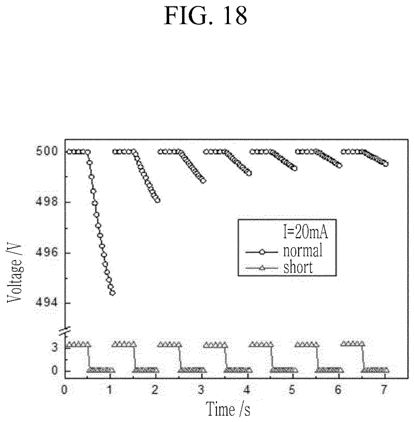

In the second operation ST2, continuous pulses having a current and voltage may be applied to the negative electrode tab 41 and the positive electrode tab 42 of the electrode assembly 40 using the continuous pulser 30. The third operation ST3 measures the voltage and the current of the continuous pulses applied to the electrode assembly 40. In the fourth operation ST4, it is determined to be short-circuited when the voltage drops to zero, and charging is determined to be complete (e.g., see FIG. 18) when the current becomes stable.

Referring to FIGS. 2 to 4 and FIG. 17, in the second to fourth embodiments, in the first operation ST1, the first plates 210, 310, and 410 and the second plates 220, 320, and 420 may be formed of first silicon pads (211, 221; 311, 321; and 411, 421) in contact with the electrode assembly 40, and second silicon pads (212, 222; 312, 322; and 412, 422) positioned on the first silicon pads to receive a pressing force, to perform pressurization (P).

In the second to fourth embodiments, in the first operation ST1, the first silicon pads (211, 221; 311, 321; and 411, 421) may be formed as a single plate, and the second silicon pads (212, 222; 312, 322; and 412, 422) may be formed into a plurality of pieces (e.g., a plurality of parts) to perform pressurization (P).

In addition, in the second to fourth embodiment, in the first operation ST1, pieces (e.g., parts) of the second silicon pads (212, 222; 312, 322; and 412, 422) may be formed to have two kinds of thicknesses and two kinds of hardnesses, to perform pressurization (P).

Referring to FIG. 2 and FIG. 17, in the second embodiment, in the first operation ST1, the first silicon pads 211 and 221 may have the same first thickness t1 and first hardness as each other, and pieces (e.g., parts) of the second silicon pads 212 and 222 may be pressurized (P) with at least one of the thickness or the hardness that is different from each other.

In more detail, in the first operation ST1, among the pieces of the second silicon pad 212 and 222, the pieces 213 and 223 positioned at a center in the width direction may have the 21st thickness t21 and the 21st hardness, and the pieces 214 and 224 positioned on the outside may have the 22nd thickness t22 greater than the 21st thickness t21. A pressure distribution as shown in FIG. 14 may be obtained.

Referring to FIGS. 3 and 17, in the third embodiment, in the first operation ST1, the first silicon pads 311 and 321 may have the same 31st thickness t31 and the first hardness as each other, the pieces of the second silicon pads 312 and 322 may have the same thickness t32 as each other, and the hardness of the pieces 314 and 324 positioned on the outside may be made higher than the hardness of the pieces 313 and 323 positioned at a center in the width direction, to perform pressurization (P). A pressure distribution as shown in FIG. 15 may be obtained.

Referring to FIGS. 4 and 17, in the third embodiment, in the first operation ST1, the first silicon pads 411 and 421 may have the same 41st thickness t41 and the first hardness as each other, the pieces of the second silicon pads 412 and 422 may be made to have the same hardness as each other, and the 44th thickness t44 of the pieces 414 and 424 positioned on the outside may be made larger than the 43rd thickness t43 of the pieces 423 and 423 positioned at a center in the width direction. A pressure distribution as shown in FIG. 16 may be obtained.

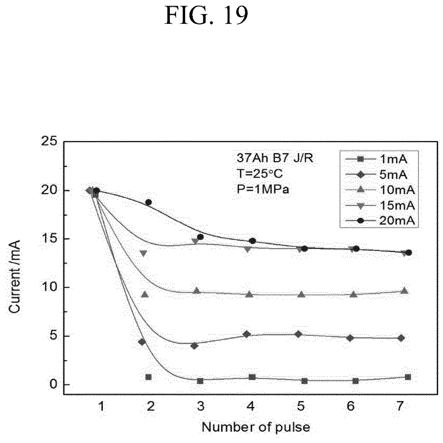

FIG. 18 illustrates a graph showing that a voltage drops to zero and is determined to be a short circuit in the test method of FIG. 17. FIG. 19 illustrates a graph showing that a current is stable and charging is determined to be complete in the test method of FIG. 17.

Referring to FIGS. 17 and 18, in the fourth operation ST4, when a voltage of the electrode assembly drops to zero (e.g., lower lines in FIG. 18), a short circuit is determined, and when a current stabilizes (e.g., upper lines in FIG. 18), charging is determined to be complete.

Referring to FIGS. 17 and 19, a balanced voltage of the electrode assembly may gradually increase as the continuous pulse current is actually applied. As an applied current increases, the ability to charge a capacitance of the electrode assembly increases.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

**Description of Symbols**

| | |
|---|---|
| 1, 2, 3, 4, 5, 6, 7: electrode assembly short circuit test apparatus | |
| 10: first plate | 20: second plate |
| 30: continuous pulser | 40, 50: electrode assembly |
| 41, 51: negative electrode tab | 42, 52: positive electrode tab |
| 43, 44: pressure sensitive paper | 210: first plate |
| 220: second plate | 211, 221: first silicon pad |
| 212, 222: second silicon pad | 213, 223: piece |
| 214, 224: piece | 310: first plate |
| 311, 321: first silicon pad | 312, 322: second silicon pad |
| 313, 323: piece | 314, 324: piece |
| 315, 325: piece | 320, 420: second plate |
| 410: first plate | 411, 421: first silicon pad |
| 412, 422: second silicon pad | 413, 423: piece |
| 414, 424: piece | 415, 425: piece |
| 510: lower plate | 520: upper plate |
| 610: lower plate | 620: upper plate |
| 621: tile-type silicon pad | 622: jig |
| 710: first plate | 720: second plate |
| 711, 721: PP sheet | 712, 722: silicon pad |
| P: press | t1: first thickness |
| t21: 21st thickness | t22: 22st thickness |
| t31: 31st thickness | t32: 32st thickness |
| t41: 41st thickness | t43: 43rd thickness |
| t44: 44th thickness | |

## Claims

1. An electrode assembly short-circuit test apparatus (1, 2, 3, 4, 5, 6, 7) for a rechargeable battery, the apparatus (1, 2, 3, 4, 5, 6, 7) comprising:
a first plate (10) configured to press a first side of an electrode assembly (40, 50), the electrode assembly (40, 50) comprising a negative electrode, a positive electrode, and a separator between the negative electrode and the positive electrode;
a second plate (20) configured to press a second side of the electrode assembly (40, 50) against the first plate (10); and
a continuous pulser (30) connected to a negative electrode tab (41) and a positive electrode tab (42) of the electrode assembly (40, 50) to apply continuous pulses to the negative electrode tab (41) and the positive electrode tab (42).

2. The electrode assembly short-circuit test apparatus (1, 2, 3, 4, 5, 6, 7) of claim 1, wherein at least one of the first plate (10) or the second plate (20) comprises a silicon pad (210, 220).

3. The electrode assembly short-circuit test apparatus (1, 2, 3, 4, 5, 6, 7) of claim 1 or 2, wherein the first plate (10) and the second plate (20) comprise:
a first silicon pad (211, 221, 311, 321, 411, 421) in contact with the electrode assembly (40, 50); and
a second silicon pad (212, 222, 312, 322, 412, 422) on the first silicon pad (211, 221, 311, 321, 411, 421) to receive a pressing force; or
wherein the first plate (10) and the second plate (20) comprise:
a first silicon pad (211, 221, 311, 321, 411, 421) in contact with the electrode assembly (40, 50); and
a second silicon pad (212, 222, 312, 322, 412, 422) on the first silicon pad (211, 221, 311, 321, 411, 421) to receive a pressing force, and
wherein the first silicon pad (211, 221, 311, 321, 411, 421) comprises a single plate, and the second silicon pad (212, 222, 312, 322, 412, 422) comprises a plurality of parts; or
wherein the first plate (10) and the second plate (20) comprise:
a first silicon pad (211, 221, 311, 321, 411, 421) in contact with the electrode assembly (40, 50); and
a second silicon pad (212, 222, 312, 322, 412, 422) on the first silicon pad (211, 221, 311, 321, 411, 421) to receive a pressing force, and
wherein the first silicon pad (211, 221, 311, 321, 411, 421) comprises a single plate, and the second silicon pad (212, 222; 312, 322, 412, 422) comprises a plurality of parts, and
wherein the parts of the second silicon pad (212, 222 312, 322, 412, 422) have two kinds of thicknesses and two kinds of hardnesses.

4. The electrode assembly short-circuit test apparatus (1, 2, 3, 4, 5, 6, 7) of claims 2 or 3, wherein the first silicon pad (211, 221, 311, 321, 411, 421) of the first and second plates (10, 20) has a same first thickness and a same first hardness, and
wherein the parts of the second silicon pad (212, 222, 312, 322, 412, 422) differ from each other in at least one of a thickness or a hardness.

5. The electrode assembly short-circuit test apparatus (1, 2, 3, 4, 5, 6, 7) of any one of claims 2 to 4, wherein, from among the parts of the second silicon pad (212, 222, 312, 322, 412, 422), a part located at a center in a width direction has a 21st thickness and a 21st hardness, and
wherein, from among the parts of the second silicon pad (212, 222, 312, 322, 412, 422), parts located on an outer edge in the width direction have a 22nd thickness greater than the 21st thickness, and a 22nd hardness greater than the 21st hardness.

6. The electrode assembly short-circuit test apparatus (1, 2, 3, 4, 5, 6, 7) of any one of claims 1 to 5, wherein the first silicon pad (211, 221, 311, 321, 411, 421) has a 31st thickness and a 31st hardness,
wherein the parts of the second silicon pad (212, 222, 312, 322, 412, 422) have a same 32nd thickness as each other,
wherein, from among the parts of the second silicon pad (212, 222, 312, 322, 412, 422), a part located at a center in a width direction has a 33rd hardness,
wherein, from among the parts of the second silicon pad (212, 222, 312, 322, 412, 422), a part located on an outer edge in the width direction has a 34th hardness, and
wherein the 33rd hardness is smaller than the 34th hardness; or
wherein the first silicon pad (211, 221, 311, 321, 411, 421) has a 41st thickness and a 41st hardness,
wherein the parts of the second silicon pad (212, 222, 312, 322, 412, 422) have a same 42nd hardness as each other,
wherein, from among the parts of the second silicon pad (212, 222, 312, 322, 412, 422), a part located at a center in a width direction has a 43rd thickness,
wherein, from among the parts of the second silicon pad (212, 222, 312, 322, 412, 422), a part located on an outer edge in the width direction has a 44th thickness, and
wherein the 43rd thickness is smaller than the 44th thickness.

7. The electrode assembly short-circuit test apparatus (1, 2, 3, 4, 5, 6, 7) of any one of claims 1 to 6, wherein the first plate (10) and the second plate (20) comprise:
a polypropylene sheet in contact with the electrode assembly (40, 50); and
a silicone pad (621) on the polypropylene sheet to receive a pressing force, and
wherein the silicon pad (210, 220) comprises a plurality of parts.

8. The electrode assembly short-circuit test apparatus (1, 2, 3, 4, 5, 6, 7) of any one of claims 1 to 7, wherein the first plate (10) comprises a PC sheet or an inclined Teflon pad, and
wherein the second plate (20) comprises:
a tile-type silicon pad (621); and
a jig configured to hold the silicon pad (621).

9. An electrode assembly short-circuit test method for a rechargeable battery, the method comprising:
performing pressurization by using a first plate (10) for supporting a lower surface of an electrode assembly (40, 50), and a second plate (20) for supporting an upper surface of the electrode assembly (40, 50) from above the first plate (10), the electrode assembly (40, 50) comprising a negative electrode, a positive electrode, and a separator between the negative electrode and the positive electrode;
applying continuous pulses having a current and a voltage using a continuous pulser (30) to a negative electrode tab (41) and a positive electrode tab (42) of the electrode assembly (40, 50);
measuring the voltage and the current of the continuous pulses applied to the electrode assembly (40, 50);
determining a short circuit if the voltage drops to zero; and
determining a charging completion if the current stabilizes.

10. The electrode assembly short-circuit test method of claim 9, wherein in the performing of the pressurization, at least one of the first plate (10) or the second plate (20) comprises a silicon pad (210, 220) to perform the pressurization; or
wherein in the performing of the pressurization, the first plate (10) and the second plate (20) comprise:
a first silicon pad (211, 221, 311, 321, 411, 421) in contact with the electrode assembly (40, 50); and
a second silicon pad (212, 222, 312, 322, 412, 422) on the first silicon pad (211, 221, 311, 321, 411, 421) to receive a pressing force to perform the pressurization; or
wherein in the performing of the pressurization, the first silicon pad (211, 221, 311, 321, 411, 421) comprises a single plate, and the second silicon pad (212, 222, 312, 322, 412, 422) comprises a plurality of parts to perform the pressurization.

11. The electrode assembly short-circuit test method of claim 9 or 10, wherein in the performing of the pressurization, the parts of the second silicon pad (212, 222, 312, 322, 412, 422) have two kinds of thicknesses and two kinds of hardnesses to perform the pressurization.

12. The electrode assembly short-circuit test method of any one of claims 9 to 11, wherein in the performing of the pressurization, the first silicon pad (211, 221, 311, 321, 411, 421) of the first plate (10) and the second plate (20) has a same first thickness and a same first hardness, and the parts of the second silicon pad (212, 222, 312, 322, 412, 422) differ from each other in at least one of a thickness or a hardness to perform the pressurization.

13. The electrode assembly short-circuit test method of any one of claims 9 to 12, wherein in the performing of the pressurization, from among the parts of the second silicon pad (212, 222, 312, 322, 412, 422), a part located at a center in a width direction has a 21st thickness and a 21st hardness, and parts located on an outer edge have a 22nd thickness greater than the 21st thickness and a 22nd hardness greater than the 21st hardness.

14. The electrode assembly short-circuit test method of any one of claims 9 to 13, wherein in the performing of the pressurization, the first silicon pad (211, 221, 311, 321, 411, 421) of the first plate (10) and the second plate (20) has a same first thickness and a same first hardness, the parts of the second silicon pad (212, 222, 312, 322, 412, 422) have a same second thickness as each other, and a hardness of parts located on an outer edge from among the parts of the second silicon pad (212, 222, 312, 322, 412, 422) is higher than a hardness of parts located at a center in a width direction from among the parts of the second silicon pad (212, 222, 312, 322, 412, 422), to perform the pressurization.

15. The electrode assembly short-circuit test method of any one of claims 9 to 14, wherein in the performing of the pressurization, the first silicon pad (211, 221, 311, 321, 411, 421) of the first plate (10) and the second plate (20) has a same first thickness and a same first hardness, and parts located on an outer edge from among the parts of the second silicon pad (212, 222, 312, 322, 412, 422) has a 44^{th} thickness that is higher than a 43rd thickness of parts located at a center in a width direction from among the parts of the second silicon pad (212, 222, 312, 322, 412, 422), to perform pressurization.
